# EUROPEAN PATENT APPLICATION

(11) **EP 0 899 793 A2**
(43) Date of publication of application: **03.03.1999**
(21) Application number: 98202868.0
(22) Date of filing: 26.08.1998
(51) Int. Cl.: H01L 29/78, H01L 29/08, H01L 21/336

(54) **Transistor having localized source and drain extensions and method**

(30) Priority: 28.08.1997 US 57378 P
(71) Applicant: TEXAS INSTRUMENTS INCORPORATED, Dallas, TX 75265 (US)
(72) Inventor: Rodder, Mark S., Texas, TX 75225 (US)
(74) Representative: Holt, Michael

(57) **Abstract**

A transistor comprising a gate electrode (22) insulated from a semiconductor layer (12). A channel region (94) may be defined in the semiconductor layer (12) inwardly of the gate electrode (22). A source region (92) may be formed in the semiconductor layer (12) between the channel region (94) and a first isolation member (16). The source region (92) may comprise a source main body (88) and a localized source extension (52). The localized source extension (52) may be spaced apart from the first isolation member (16) and extend from the source main body (88) to the channel region (94). A drain region (96) may be formed in a semiconductor layer (12) between the channel region (94) and a second isolation member (18). The drain region (96) may comprise a drain main body (90) and a localized drain extension (54). The localized drain extension (54) may be spaced apart from the second isolation member (18) and extend from the drain main body (90) to the channel region (94).

## Description

This invention relates generally to the field of semiconductor devices, and more particularly to a transistor having localized source and drain extensions and to a method of making the same.

Modern electronic equipment such as televisions, telephones, radios and computers are generally constructed of solid state devices. Solid state devices are preferred in electronic equipment because they are extremely small and relatively inexpensive. Additionally, solid state devices are very reliable because they have no moving parts, but are based on the movement of charge carriers.

Solid state devices include transistors, capacitors, resistors and the like. Transistors typically include source and drain regions separated by a channel region. A gate controls the flow of current from the source region to the drain region through the channel region.

Increasingly, transistors and other solid state devices are made smaller to reduce the size of electronic equipment. For transistors, the smaller size compels a narrow gate which can lead to short-channel effects between the source and drain regions To compensate for the short channel, source and drain extensions may be used to extend the source and drain regions to the channel region. Pockets may be used in connection with the source and drain extensions to reduce gate length sensitivity of drive current.

An issue with pockets is the junction capacitance between the source or drain and pocket. Junction capacitance can increase delay in the transistor and correspondingly reduce circuit speed. The extensions may also result in additional implant damage in the source and drain regions.

An illustrative embodiment of the present invention seeks to provide a transistor having localized source and drain extensions and pockets that substantially eliminate or reduce the disadvantages and problems associated with prior systems and methods.

Aspects of the invention are specified in the claims. In carrying out principles of the present invention a transistor may comprise a gate electrode insulated from a semiconductor layer. A channel region may be defined in the semiconductor layer inwardly of the gate electrode. A source region may be formed in the semiconductor layer between the channel region and a first isolation member. The source region may comprise a source main body and a localized source extension. The localized source extension may be spaced apart from the first isolation member and extend from the source main body to the channel region. A drain region may be formed in a semiconductor layer between the channel region and a second isolation member. The drain region may comprise a drain main body and a localized drain extension. The localized drain extension may be spaced apart from the second isolation member and extend from the drain main body to the channel region.

More specifically, in accordance with one embodiment of the present invention, the localized source extension may overlap part of the source main body and the localized drain extension may overlap part of the drain main body. The source main body may abut the first isolation member and the drain main body abut the second isolation member. In this and other embodiments, the localized source extension may extend less than half a distance between the gate electrode and the first isolation member. The localized drain extension may extend less than half a distance between the gate electrode and the second isolation member.

A localized source pocket may be formed in the semiconductor layer. The source pocket may bound an inner perimeter of the localized source extension. A localized drain pocket may also be formed in the semiconductor layer. The drain pocket may bound an inner perimeter of the localized drain extension.

Important technical advantages of the present invention include providing an improved transistor having localized source and drain extensions that reduce implant damage effects. Accordingly, the main body and contacts of the source and drain regions may be formed with minimal interference from the extensions.

Another technical advantage of the present invention includes providing localized source and drain pockets. In particular, the source and drain pockets may bound the extensions and be spaced apart from isolation members. Accordingly, the pockets also do not extend across the entire active area and thus, the transistor may be more quickly charged and circuit speed correspondingly increased due to reduced junction capacitance.

Still another technical advantage of the present invention includes providing an improved method of forming source and drain extensions and pockets. In particular, a photoresist masking layer may be formed over the semiconductor layer exposing first and second sections of the active area proximate to the gate electrode. Dopants may be implanted into the exposed sections to form the localized source and drain extensions. Further dopants may be implanted into the exposed sections to form the source and drain pockets. The photoresist masking layer may then be removed by conventional methodology. Accordingly, the localized source and drain extensions and pockets may be formed using conventional integrated circuit processing techniques and equipment.

Other technical advantages will be readily apparent to one skilled in the art from the following figures, description and claims.

For a more complete understanding of the present invention and its advantages thereof, reference is now made to the following description taken in conjunction with the accompanying drawings, wherein like reference numerals represent like parts, in which:
FIGURES 1A-E are a series of schematic cross-sectional diagrams illustrating fabrication of a transistor with localized source and drain extensions and pockets in accordance with one embodiment of the present invention;
FIGURES 2A-B are a series of schematic top plan diagrams illustrating a plurality of transistors with active areas formed in a semiconductor layer and a mask exposing limited sections of each active area in accordance with one embodiment of the present invention; and
FIGURES 3A-B are a series of schematic cross-sectional diagrams illustrating four-rotational angled implant doping of the exposed sections of the transistor active areas to form the localized source and drain extensions and pockets in accordance with one embodiment of the present invention.

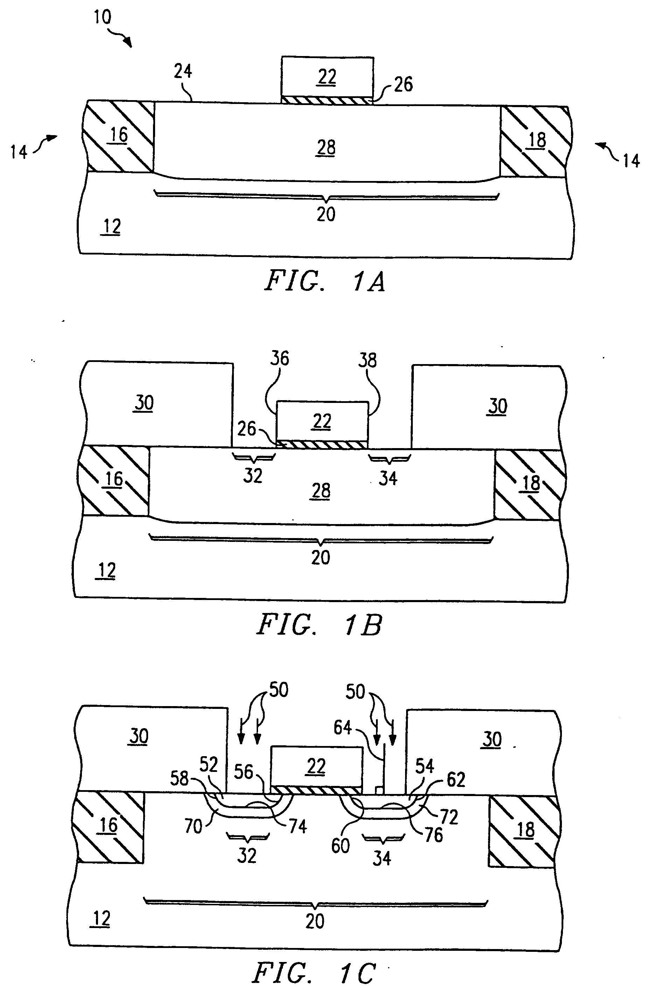

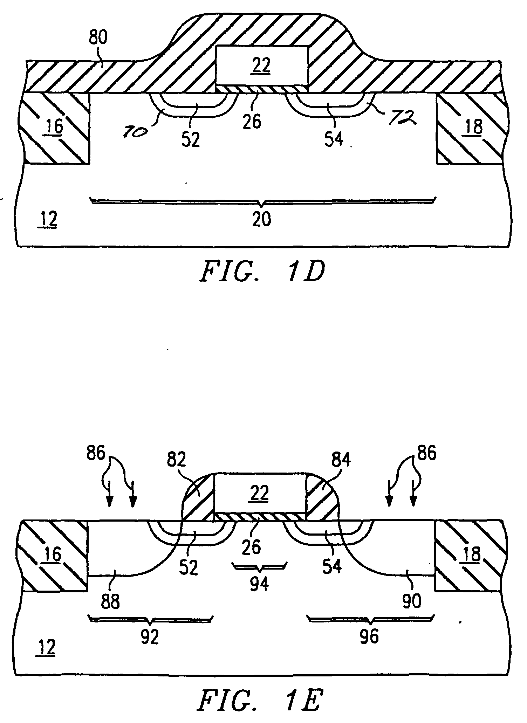

The preferred embodiments of the present invention and its advantages are best understood by referring now in more detail to FIGURES 1-3 of the drawings, in which like numerals refer to like parts throughout the several views. FIGURES 1-3 illustrate fabrication of transistors having localized source and drain extensions and localized pockets and/or ultrashallow source and drain junctions and ultrashallow pockets with reduced gate overlap. As described in more detail below, the localized source and drain extensions may reduce implant damage to the source and drain regions. The localized pockets may reduce capacitance of the source and drain regions. The ultrashallow junctions with minimal gate overlap may also reduce overlap capacitance to the gate electrode. Accordingly, the transistor may be more quickly charged and circuit speed correspondingly increased.

FIGURES 1A-E are a series of schematic cross-sectional diagrams illustrating fabrication of a transistor with localized source and drain extensions and pockets in accordance with one embodiment of the present invention. In this embodiment, the transistor may be a metal oxide semiconductor field effect transistor (MOSFET) of a sub-micron regime. It will be understood that the type and size of the transistor may be varied.

Referring to FIGURE 1A, an initial semiconductor structure 10 may comprise a semiconductor layer 12. The semiconductor layer 12 may be a substrate such as a wafer. In this embodiment, the semiconductor layer 12 may comprise a single-crystalline silicon material. It will be understood that the semiconductor layer 12 may also be a layer of semiconductor material formed on a substrate. For example, the semiconductor layer 12 may be an epitaxial layer grown on a wafer.

A first isolation member 16 and a second isolation member 18 may be formed in the semiconductor layer 12. The isolation members 16 and 18 may be independent structures or part of a unitary structure. For sub-micron applications, the isolation members 16 and 18 may comprise shallow isolation trenches. It will be understood that other types of isolation members and/or structures may be used. For example, the isolation members 16 and 18 may comprise a field oxide.

The isolation members 16 and 18 may define an active area 20 in the semiconductor layer 12. As described in more detail below, source, drain and channel regions may be defined in the active area 20. A gate electrode may control the flow of current from the source region to the drain region through the channel region to operate the transistor. It will be understood that the active area 20 may comprise other regions.

A gate electrode 22 may be disposed over and insulated from the active area 20. In one embodiment, the gate electrode 22 may be separated from an outer surface 24 of the active area 20 by a gate insulator 26. In this embodiment, the gate electrode 22 may comprise polycrystalline silicon or other suitable semiconductor material. The gate insulator 26 may comprise silicon dioxide or other suitable insulating material. It will be understood that the gate electrode 22 may be otherwise associated with the active area 20.

In a particular embodiment, the transistor may comprise an n-MOS transistor. In this embodiment, the active area 20 may comprise a p-well 28 formed in the semiconductor layer 12. The p-well 28 may comprise the single-crystalline silicon material of the semiconductor layer 12 slightly doped with the p-type dopant such as boron. It will be understood that the semiconductor layer 12 may comprise other materials or be otherwise doped. For example, the semiconductor layer 12 may itself be slightly doped eliminating the need for the well 28.

Referring to FIGURE 1B, a masking layer 30 may be formed over the semiconductor layer 12 and expose a first section 32 and a second section 34 of the active area 20. In one embodiment, the exposed first section 32 may be proximate to a first side 36 of the gate electrode 22 facing the first isolation member 16. The exposed second section 34 may be proximate to a second side 38 of the gate electrode 22 facing the second isolation member 18. It will be understood that the sections 32 and 34 exposed by the masking layer 30 may vary.

The thickness of the masking layer 30 may vary. As described in more detail below, the masking layer 30 may have a predefined thickness based on the size of the exposed sections 32 and 34 and on an implant angle of dopants into the exposed sections 32 and 34. It will be understood that the thickness of the masking layer 30 may be independently set or depend on other parameters.

In one embodiment, the masking layer 30 may comprise photoresist material. In this embodiment, the masking layer 30 may be conventionally coated, patterned and etched to expose the first and second sections 32 and 34 of the active area 20. It will be understood that the masking layer 30 may comprise other materials and/or be otherwise formed.

Referring to FIGURE 1C, dopants 50 may be implanted into the exposed first section 32 to form at least part of a source region and into the exposed second section 34 to form at least part of a drain region. The dopants may be implanted in accordance with conventional integrated circuit processing techniques. In one embodiment, the doped exposed first section 32 may comprise a source extension 52. The doped exposed second section 34 may comprise a drain extension 54. It will be understood that the exposed first and second sections 32 and 34 of the active area 20 may comprise other elements of the source and drain regions.

In accordance with the present invention, the source extension 52 is localized in that it is spaced apart from the first isolation member 16 and thus does not extend the distance between the gate electrode 22 and the first isolation member 16. Similarly, the drain extension 54 is localized in that it is spaced apart from the second isolation member 18 and thus does not extend the full distance between the gate electrode 22 and the second isolation member 18. Accordingly, the localized source and drain extensions 52 and 54 reduce implant damage to the source and drain regions. Accordingly, the main body and contacts of the source and drain regions may be formed with minimal interference from the extensions.

In one embodiment, the localized source extension 52 may have a first channel end 56 disposed slightly under the gate electrode 22 and an opposite second end 58 disposed toward but spaced apart from the first isolation member 16. Similarly, the localized drain extension 54 may have a first channel end 60 disposed slightly under the gate electrode 22 and an opposite second end 62 disposed toward but spaced apart from the second isolation member 18. In this embodiment, the localized source extension 52 may extend less than half the distance between the gate electrode 22 and the first isolation member 16 while the localized drain extension 54 extends less than half the distance between the gate electrode 22 and the second isolation member 18. In a particular embodiment, the localized source and drain extensions 52 and 54 may each be less than 0.3-0.4 microns in length beyond the edge of the gate electrode 22. It will be understood that the localized source and drain extensions 52 and 54 may be of other absolute or relative lengths.

The localized source and drain extensions 52 and 54 may each vertically overlap the gate electrode 22 by approximately 100-200 angstroms. This overlap may be induced by thermal treatment or other migration of the implanted dopants. It will be understood that the localized source and drain extensions 52 and 54 may be otherwise disposed with' respect to the gate electrode 22.

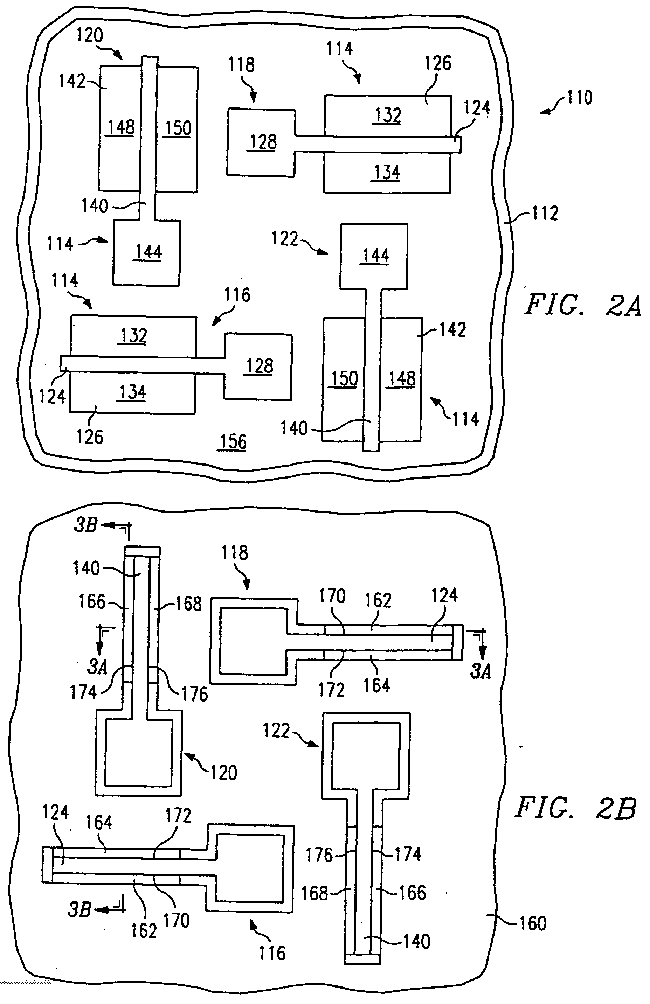

As previously described, the masking layer 30 may have a predefined thickness based on an implant angle of the dopants 50 and on the size of the exposed sections 32 and 34 of the active area 20. In one embodiment, the dopants 50 may be implanted at an angle of substantially zero degrees from a perpendicular 64 to the semiconductor layer 12. The exposed sections 32 and 34 may be sized between 0.1-0.3 microns. In this embodiment, the masking layer 30 may have a thickness of 0.3-1.3 microns. It will be understood that the masking layer 30 may comprise other thicknesses, the dopants 50 may be implanted at other angles and that the exposed sections 32 and 34 may be otherwise sized. For example, as described below in connection with FIGURES 2-3, the dopants 50 may be implanted at an angle to produce ultrashallow extensions 52 and 54. In this embodiment, the dopants 50 may be implanted from a direction substantially parallel to the gate electrode 22. The masking layer 30 may block entry of dopants implanted from non-parallel directions to the gate electrode 22 into the exposed sections 32 and 34 of the active area 20.

Pocket dopants may be implanted into the exposed sections 32 and 34 inwardly of the extensions 52 and 52 to form a source pocket 70 and a drain pocket 72. The pockets 70 and 72 may be used in connection with the extensions 52 and 54 to reduce gate length sensitivity of drive current. In one embodiment, the pocket dopants may be the dopants of the opposite type used to form the extensions 52 and 54, but be implanted in the semiconductor layer 12 at a higher energy. It will be understood that the pockets 70 and 72 may comprise dopants otherwise introduced. For example, the pocket dopants may be implanted at the same or other energy.

The source pocket 70 may be localized and bound an inner perimeter 74 of the localized source extension 52. The drain pocket 72 may be similarly localized and bound an inner perimeter 76 of the localized drain extension 54. It will be understood that the source and drain pockets 70 and 72 may be otherwise configured. It will be understood that the pockets 70 and 72 may be localized independently of the extensions 52 and 54.

For the n-MOS transistor embodiment, the localized source and drain extensions 52 and 54 may each comprise n-type dopants such as arsenic. In this embodiment, the localized source and drain pockets 70 and 72 may comprise p-type dopants such as boron or indium. It will be understood that the localized source and drain extensions 52 and 54 and pockets 70 and 72 may be otherwise doped.

In one embodiment, the dopants 50 may be implanted to a moderately doped concentration. In this embodiment, the dopants 50 may be implanted to a concentration of about 1-2E19/CM³. In another embodiment, the dopants 50 may be implanted to a heavily doped concentration. In this embodiment, the dopants 50 may be implanted to a concentration of about 1-2E20/CM³. It will be understood that dopants 50 may be implanted to other concentrations.

After the localized source and drain extensions 52 and 54 and pockets 70 and 72 have been formed, the masking layer 30 may be removed. For the photoresist embodiment of the masking layer 30, the masking layer 30 may be removed by conventional processing. It will be understood that the masking layer 30 may be otherwise removed.

Referring to FIGURE 1D, an insulating layer 80 may be deposited outwardly of the semiconductor layer 12 and the gate electrode 22. In one embodiment, the insulating layer 80 may be deposited directly onto the semiconductor layer 12 and the gate electrode 22. In this embodiment, the insulating layer 80 may comprise an oxide and/or nitride layer. It will be understood that the insulating layer 80 may comprise other materials capable of insulating semiconductor elements.

Referring to FIGURE 1E, the insulating layer 80 may be anisotropically etched to form a first sidewall 82 adjacent the first side 36 of the gate electrode 22 and a second sidewall 84 adjacent the second side 38 of the gate electrode 22. The anisotropic etch may be a conventional reactive ion etch (RIE) using processes well known in the art. The sidewalls 82 and 84 may electrically isolate sides 36 and 38 of the gate electrode 22 from other elements of the transistor.

Dopants 86 may be implanted into the exposed portions of the active area 20 between the first sidewall 82 and isolation member 16 to form a source main body 88 and between the second sidewall 84 and isolation member 18 to form a drain main body 90. Accordingly, the dopant implant process to form the source and drain main bodies 88 and 90 is self-aligned between the respective sidewalls 82 and 84 and isolation structures 16 and 18. It will be understood that the source and drain main bodies 88 and 90 may be otherwise formed.

The source region may comprise the source main body 88, the localized source extension 52 and the localized source pocket 70. In this embodiment, the source main body 88 may abut the first isolation member 16 and extend to overlap the localized source extension 52. The source main body 88 may be laterally spaced apart from the gate electrode 22. The localized source 52 may extend from the source main body 88 to a channel region 94 defined in the semiconductor layer 12 inwardly of the gate electrode 22. It will be understood that the source region and/or main body 88 may be otherwise configured.

The drain region may similarly comprise the drain main body 90, the localized drain extension 54 and the localized drain pocket 72. In this embodiment, the drain main body 90 may abut the second isolation member 18 and extend to overlap the localized drain extension 54. The drain main body 90 may be laterally spaced apart from the gate electrode 22. The localized drain extension 54 may extend from the drain main body 90 to the channel region 94. It will be understood that the drain region and/or main body 90 may be otherwise configured.

FIGURES 2-3 illustrate fabrication of transistors having ultrashallow junctions with reduced gate overlap in accordance with one embodiment of another aspect of the present invention. In this embodiment, the transistors may be metal oxide semiconductor field effect transistors (MOSFET) of a sub-micron regime. It will be understood that the type and size of the transistors may vary.

Referring to FIGURE 2A, an initial semiconductor structure 110 may comprise a semiconductor layer 112. As previously described in connection with the semiconductor layer 12, the semiconductor layer 112 may be a substrate such as a wafer. In this embodiment, the semiconductor layer 112 may comprise a single-crystalline silicon material. It will be understood that the semiconductor layer 112 may also be a layer of semiconductor material formed on a substrate. For example, the semiconductor layer 112 may be an epitaxial layer grown on a wafer.

Transistors 114 may be formed on the semiconductor layer 112. In one embodiment, the transistors 114 may be arranged in different directions to increase circuit density. In this embodiment, the transistors 114 may be arranged with adjacent transistors perpendicular to one another and once removed transistors that are adjacent to adjacent transistors parallel to one another. Thus, transistor 116 may be parallel to once removed transistor 118 and perpendicular to adjacent transistors 120 and 122. It will be understood that the transistors 114 may be otherwise arranged.

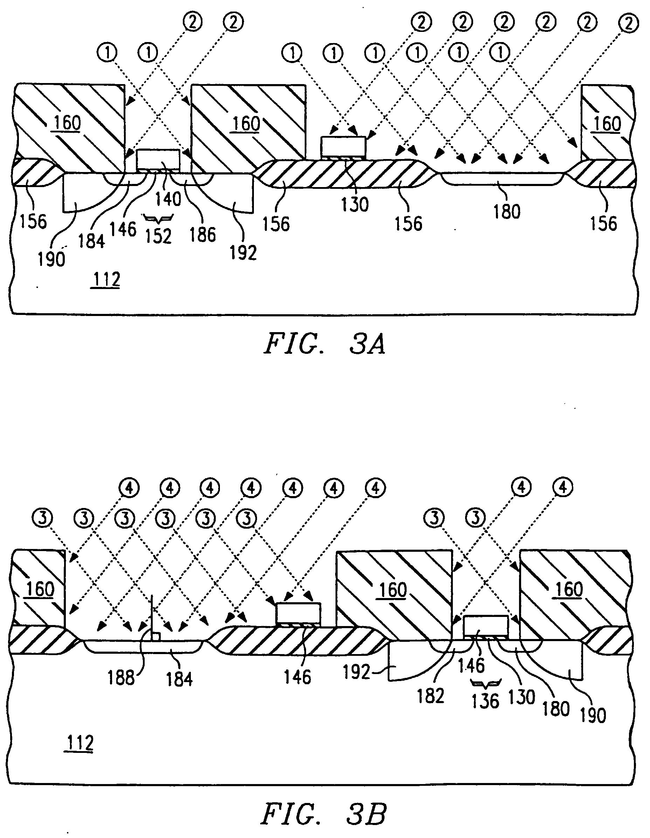

In the MOSFET transistor embodiment, parallel transistors 116 and 118 may each comprise a gate electrode 124 disposed over and insulated from an active area 126. The gate electrode 124 may include an enlarged contact area 128 and be insulated from the outer surface of the active area 126 by a gate insulator 130 (FIGURES 3). The gate electrode 124 may comprise polycrystalline silicon or other suitable semiconductor material. The gate insulator 130 may comprise silicon dioxide or other suitable insulating material.

The active areas 126 may each comprise a source region 132 separated from a drain region 134 by a channel region 136 (FIGURES 3). The gate electrode 124 may control the flow of current from the source region 132 to the drain region 134 through the channel region 136 to operate the transistor 116 or 118. It will be understood that the active area 126 may comprise other regions.

Transistors 116 and 118 may be parallel to each other in that their gate electrodes 124 and/or source and drain regions 132 and 134 are parallel to each other. It will be understood that the transistors 116 and 118 may be otherwise parallel to each other.

Parallel transistors 120 and 122 may each comprise a gate electrode 140 disposed over and insulated from an active area 142. The gate electrode 140 may include an enlarged contact area 144 and be insulated from the outer surface of the active area 142 by a gate insulator 146 (FIGURES 3). The gate electrode 140 may comprise polycrystalline silicon or other suitable semiconductor material. The gate insulator 146 may comprise silicon dioxide or other suitable insulating material.

The active areas 142 may each comprise a source region 148 separated from a drain region 150 by a channel region 152 (FIGURES 3). The gate electrode 140 may control the flow of current from the source region 148 to the drain region 150 through the channel region 152 to operate the transistor 120 or 122. It will be understood that the active area 142 may comprise other regions.

Transistors 120 and 122 may be parallel to each other in that their gate electrodes 140 and/or source and drain regions 148 and 150 are parallel to each other. It will be understood that the transistors 120 and 122 may be otherwise parallel to each other. Transistors 120 and 122 may be perpendicular to transistors 116 and 118 in that their gate electrodes 140 and/or source and drain regions 148 and 150 are perpendicular to gate electrodes 124 and/or source and drain regions 132 and 134. It will be understood that the transistors 120 and 122 may be otherwise perpendicular to transistors 116 and 118.

In a particular embodiment, the transistors 114 may comprise n-MOS transistors. In this embodiment, as previously described in connection with the active area 20, the active areas 126 and 142 may each comprise a p-well formed in the semiconductor layer 112. The p-well may comprise the single-crystalline silicon material of the semiconductor layer 112 slightly doped with a p-type dopant such as boron. It will be understood that the semiconductor layer 112 may comprise other materials or be otherwise doped. Additionally, in a complimentary transistor embodiment having n-MOS and p-MOS transistors, the active areas 126 and/or 142 of the p-MOS transistors may comprise an n-well.

An isolation structure 156 may be formed on the semiconductor layer 112 and isolate the transistors 114. In one embodiment, the transistors 114 may be formed in windows of the isolation structure 156. In this embodiment, the isolation structure 156 may comprise a conventional field oxide. The windows for the transistors may be formed using conventional photolithography techniques associated with pattern and etching. It will be understood that other types of isolation structures may be used. For example, the isolation structure 156 may comprise independent isolation trenches and the like.

Referring to FIGURE 2B, a masking layer 160 may be formed over the semiconductor layer 112 and expose limited sections of the active areas 126 and 142 of the transistors 114. In one embodiment, the exposed sections may include source sections 162 and drain section 164 of active areas 126 (FIGURE 2A) and source sections 166 and drain sections 168 of active areas 142 (FIGURE 2A). In this embodiment, each source section 162 may be proximate to a source side 170 of the gate electrode 124 and each drain section 164 may be proximate to a drain side 172 of the gate electrode 124. Each source section 166 may be proximate to a source side 174 of the gate electrode 140 and each drain section 168 may be proximate to a drain side 176 of the gate electrode 140. It will be understood that other sections of the active areas may be exposed by the masking layer 160.

The thickness of the masking layer 160 may vary. As described in more detail below, the thickness of the masking layer 160 may be predefined based on the size of the exposed sections 162, 164, 166 and 168 and on a dopant implant angle into the exposed sections 162, 164, 166 and 168. It will be understood that the thickness of the masking layer 160 may be independently set or dependent on other parameters

In one embodiment, the masking layer 160 may comprise photoresist material. In this embodiment, as described in connection with the masking layer 30, the masking layer 160 may be conventionally patterned to expose sections 162, 164, 166 and 168. It will be understood that the masking layer 160 may comprise other materials.

FIGURES 3A-B are a series of schematic cross-sectional diagrams illustrating four-rotational angled implant doping of the exposed sections 162, 164, 166 and 168 to form ultrashallow source and drain junctions and/or pockets with reduced gate overlap in accordance with one embodiment of the present invention. In this embodiment, the dopants may be implanted from four directions spaced 90 degrees apart. Preferably, the directions are each parallel and perpendicular to the gate electrodes 124 and 140. It will be understood that other implant schemes may be used.

Referring to FIGURE 3A, dopants may be implanted at an implant angle from a first direction "1" substantially parallel to the gate electrodes 124 and substantially perpendicular to the gate electrodes 140. The first direction dopants may enter into the source sections 162 to form ultrashallow source junctions 180 and into the drain sections 164 to form ultrashallow drain junctions 182 of the gate electrodes 124 parallel to the first direction. The masking layer 160 may block entry of dopants from the first direction into the source and drain sections 166 and 168 of the gate electrodes 140 perpendicular to the first direction. Accordingly, the dopants may be implanted from the first direction into the source and drain sections 162 and 164 without being implanted under the gate electrodes 140 perpendicular to the first direction.

Dopants may be implanted at the implant angle from a second direction "2" substantially opposite the first direction and parallel to the gate electrodes 124. The second direction dopants may enter into the source sections 162 to further form the ultrashallow source junctions 180 and into the drain sections 164 to further form the ultrashallow drain junctions 182 of the gate electrodes 124 parallel to the second direction. The masking layer 160 may block entry of the dopants from the second direction into the source and drain sections 166 and 168 of the gate electrodes 140 perpendicular to the second direction. Accordingly, the dopants may be further implanted from the second direction into the source and drain sections 162 and 164 without being implanted under the gate electrodes 140 perpendicular to the second direction.

Referring to FIGURE 3B, dopants may be implanted at the implant angle from a third direction "3" substantially perpendicular to the first and second directions and parallel to the gate electrodes 140. The third direction dopants may be implanted into source sections 166 to form ultrashallow source junctions 184 and into drain sections 168 to form ultrashallow drain junctions 186 of gate electrodes 140 parallel to the third direction. The masking layer 160 may block entry of dopants from the third direction into the source and drain sections 162 and 164 of the gate electrodes 124 perpendicular to the third direction. Accordingly, the dopants may be implanted from the third direction into the source and drain sections 166 and 168 without being implanted under the gate electrodes 124 perpendicular to the third direction.

Dopants may be implanted at the implant angle from a fourth direction "4" substantially opposite the third direction and parallel to the gate electrodes 140. The fourth direction dopants may enter into the source sections 166 to further form the ultrashallow source junctions 184 and into the drain sections 168 to further form the ultrashallow drain junctions 186 of the gate electrodes 140 parallel to the fourth direction. The masking layer 160 may block entry of the dopants from the fourth direction into the source and drain sections 162 and 164 of the gate electrodes 124 perpendicular to the fourth direction. Accordingly, dopants may be implanted from the fourth direction into the source and drain sections 166 and 164 without being implanted under the gate electrodes 124 perpendicular to the fourth direction.

For the n-MOS transistor embodiment, the source and drain extensions may each comprise n-type dopants such as arsenic. The dopants may be implanted to moderate, heavy or other concentrations. In the moderately doped concentration embodiment, the dopants may be implanted to the concentration of about 1-2E19/CM³. In the heavily doped concentration embodiment, the dopants may be implanted to a concentration of about 1-2E20/CM³. It will be understood that the dopants may be otherwise implanted to other concentrations

The implant angle of dopants may vary. Generally, the larger the implant angle from a perpendicular 188 of the semiconductor layer 12, the shallower the resulting source and drain junctions. In one embodiment, the dopants may be implanted at an angle of 7-30 degrees from the perpendicular 188. In this embodiment, the exposed sections 162, 164, 166 and 168 may each be sized between 0.1-0.3 microns and the masking layer 160 may have a thickness of 0.3-1.3 microns. It will be understood that the implant angle of the dopants may vary within in the scope of the present invention.

From the foregoing, dopants may be implanted from different directions at an angle to produce ultrashallow source and drain junctions. The masking layer blocks entry of dopants from nonparallel directions into the gate electrodes to prevent implantation under the gate electrodes and thus minimizes gate overlap. Accordingly, the transistors have a reduced gate overlap capacitance and may be more quickly charged for faster circuit speeds.

In one embodiment, the ultrashallow source junctions 180 and 184 may each comprise the localized source extension 52 and the ultrashallow drain junctions 182 and 186 may each comprise the localized drain extension 54. As previously described in connection with source and drain extensions 52 and 54, the source and drain pockets may be implanted inwardly of the extensions. The masking layer 160 may be the masking layer 30 and may be removed to allow formation of source and drain main bodies 190 and 192 in the semiconductor layer 112. It will be understood that the ultrashallow source and drain junctions 180, 182, 184 and 186 may comprise other source and drain structures.

In this embodiment, the size of the exposed sections may be defined based on the desired size of the extensions and/or pockets, the implant angle may be defined based on the desired depth of the extensions and/or pockets and the masking layer deposited to a thickness that blocks entry of dopants from substantially perpendicular directions. In a particular embodiment, the exposed sections may be sized between 0.1-0.3 microns, the implant angle may be 7-30 degrees from the perpendicular 188 and a four rotational implant may be used with the masking layer having a thickness of 0.3-1.3 microns. The resulting transistors may have localized and ultrashallow source and drain extensions and pockets that greatly reduce capacitance of the transistor.

Although the present invention has been described with several embodiments, various changes and modifications may be suggested to one skilled in the art. It is intended that the present invention encompass such changes and modifications as fall within the scope of the appended claims.

## Claims

1. A transistor, comprising:
a gate electrode insulated from a semiconductor layer;
a channel region defined in the semiconductor layer inwardly of the gate electrode;
a source region formed in the semiconductor layer between the channel region and a first isolation member, comprising:
a source main body;
a localized source extension spaced apart from the first isolation member and extending from the source main body to the channel region;
a drain region formed in the semiconductor layer between the channel region and a second isolation member, comprising:
a drain main body;
a localized drain extension spaced apart from the second isolation member and extending from the drain main body to the channel region;
a localized source pocket formed in the semiconductor layer and bounding an inner perimeter of the localized source extension; and
a localized drain pocket formed in the semiconductor layer and bounding an inner perimeter of the localized drain extension.

2. The transistor of Claim 1, further comprising:
the source main body abutting the first isolation member; and
the drain main body abutting the second isolation member.

3. The transistor of Claim 1 or Claim 2, further comprising:
the localized source extension overlapping part of the source main body; and
the localized drain extension overlapping part of the drain main body.

4. The transistor according to any preceeding Claim, further comprising:
the localized source extension having a depth of less than 0.08 microns; and
the localized drain extension having a depth of less than 0.08 microns.

5. The transistor according to any preceeding Claim , further comprising:
the localized source extension extending less than half a distance between the gate electrode and the first isolation member; and
the localized drain extension extending less than half a distance between the gate electrode and the second isolation member.

6. A method of making a transistor, comprising the steps of:
forming a first and a second isolation member defining an active area in a semiconductor layer;
forming a gate electrode separated from the active area of the semiconductor layer by a gate insulator;
forming a localized source extension in the semiconductor layer proximate to a first side of the gate electrode facing the first isolation member and spaced apart from the first isolation member;
forming a localized drain extension in the semiconductor layer proximate to a second side of the gate electrode facing the second isolation member and spaced apart from the second isolation member;
forming a source main body in the active region between the localized source extension and the first isolation member;
forming a drain main body in the active region between the localized drain extension and the second isolation member;
forming a localized source pocket in the semiconductor layer bounding an inner perimeter of the localized source extension; and
forming a localized drain pocket in the semiconductor layer bounding an inner perimeter of the localized drain extension.

7. The method of Claim 6, the steps of forming the localized source and drain extensions further comprising the steps of:
forming a masking layer over the semiconductor layer exposing a first section of the active area proximate to the first side of the gate electrode facing the first isolation member and a second section of the active area proximate to the second side of the gate electrode facing the second isolation member;
implanting dopants into the exposed first section, of the active area to form the localized source extension;
implanting dopants into the exposed second section of the active area to form the localized drain extension; and
removing the masking layer.

8. The method of Claim 6 or Claim 7, the steps of implanting dopants comprising implanting dopants at substantially zero degrees from perpendicular to the semiconductor layer.

9. The method of any of Claims 6 to 8, the steps of forming the localized source and drain extensions and the localized source and drain pockets further comprising the steps of:
forming a masking layer over the semiconductor layer exposing a first section of the active area proximate to the first side of the gate electrode facing the first isolation member and a second section of the active area proximate to the second side of the gate electrode facing the second isolation member;
implanting dopants into the exposed first section of the active area to form the localized source extension;
implanting dopants into the exposed first section of the active area to form the localized source pocket, the localized source pocket dopants being inwardly of the localized source extension dopants;
implanting dopants into the exposed second section of the active area to form the localized drain extension;
implanting dopants into the exposed second section of the active area to form the localized drain pocket, the localized drain pocket dopants being inwardly of the localized drain extension dopants; and
removing the masking layer.

10. The method of any of Claims 6 to 9, the steps of forming the source and the drain main bodies further comprising the steps of:
forming a first sidewall adjacent the first side of the gate electrode;
forming a second sidewall adjacent the second side of the gate electrode;
implanting dopants into the active region between the first sidewall and the first isolation member to form the source main body; and
implanting dopants into the active region between the second sidewall and the second isolation member to form the drain main body.
